# EUROPÄISCHE PATENTANMELDUNG

(11) **EP 4 067 004 A1**
(43) Veröffentlichungstag der Anmeldung: **05.10.2022**
(21) Anmeldenummer: 21166109.5
(22) Anmeldetag: 30.03.2021
(51) Int. Cl.: B25F 5/00

(54) **VERFAHREN UND ARBEITSGERÄT MIT GERÄUSCHANPASSUNG**

(71) Anmelder: Andreas Stihl AG & Co. KG, 71336 Waiblingen (DE)
(72) Erfinder: JUNKER, Sebastian, 71634 Ludwigsburg (DE); TOSSENBERGER, Sid, 81377 München (DE)
(74) Vertreter: Zurhorst, Stefan

(57) **Zusammenfassung**

Die Erfindung betrifft ein Verfahren zur Geräuschanpassung eines durch einen elektrischen Antriebsmotor (2) angetriebenen handgeführten Arbeitsgerätes mittels eines Geräuschgenerators (3) sowie ein handgeführtes Arbeitsgerät mit einem dazu ausgelegten Geräuschgenerator (3). Das Arbeitsgerät erzeugt im Betrieb ein unkorrigiertes Betriebsgeräusch (B). Mittels des Geräuschgenerators (3) wird im Betrieb zusätzlich zum unkorrigierten Betriebsgeräusch (B) ein Ergänzungsgeräusch (E) erzeugt, welches sich mit dem Betriebsgeräusch zu einem Gesamtgeräusch mit einem Gesamtschalldruckpegel (LGₚ) überlagert. Dabei liegt der Hauptanteil des Ergänzungsgeräusches (E) in einem Anpassungsspektrum (F_{A}) unterhalb von 1 kHz.

## Beschreibung

Die Erfindung betrifft ein Verfahren zur Geräuschanpassung eines durch einen elektrischen Antriebsmotor angetriebenen handgeführten Arbeitsgerätes mittels eines Geräuschgenerators, ein dazu ausgelegtes handgeführtes Arbeitsgerät, sowie eine geeignete Umrüstanordnung.

Handgeführte Arbeitsgeräte werden je nach Einsatzzweck entweder mit einem Verbrennungsmotor oder mit einem Elektromotor ausgestattet. Bei Arbeitsgeräten mit hoher Antriebsleistung dominieren die Verbrennungsmotoren. Das markante Betriebsgeräusch eines solchen mit Verbrennungsmotor angetriebenen Arbeitsgerätes signalisiert Kraft und Leistungsfähigkeit. Aus dem Betriebsgeräusch kann der erfahrene Benutzer den aktuellen Betriebszustand und auch die anliegende Betriebslast ablesen und einschätzen.

Elektrisch angetriebene Arbeitsgeräte sind im Vergleich dazu leiser. Dieser Umstand und auch die fehlenden Abgase machen solche Geräte besonders gut einsetzbar in dicht besiedelter Umgebung. Akku-gespeiste Geräte sind zudem in ihrem Betrieb nicht durch ein Netzkabel oder überhaupt durch das Vorhandensein eines Netzspannungsanschlusses eingeschränkt. Auch die Leistungsfähigkeit der elektrisch angetriebenen Geräte hat mittlerweile ein beachtliches Niveau erreicht.

Gleichwohl hat das vergleichsweise geringe Geräuschniveau nicht nur Vorteile. Die akustische Rückmeldung des Arbeitseinsatzes an den Benutzer ist geringer, so dass die Einschätzung der Arbeitssituation schwieriger ist. Die Leistungsfähigkeit wird geringer eingeschätzt als sie tatsächlich ist. Die Akzeptanz als vollwertiges Arbeitsgerät ist beeinträchtigt, was der ansonsten wünschenswerten Substitution des Verbrennungsantriebes durch einen Elektroantrieb entgegensteht.

Der Erfindung liegt die Aufgabe zugrunde, ein Verfahren zur Geräuschanpassung eines durch einen elektrischen Antriebsmotor angetriebenen handgeführten Arbeitsgerätes anzugeben, welches die akustische Rückmeldung an den Benutzer verbessert.

Diese Aufgabe wird durch ein Verfahren mit den Merkmalen des Anspruchs 1 gelöst.

Der Erfindung liegt des Weiteren die Aufgabe zugrunde, ein hierzu angepasstes Arbeitsgerät anzugeben.

Diese Aufgabe wird durch ein handgeführtes Arbeitsgerät mit den Merkmalen des Anspruchs 11 gelöst.

Der Erfindung liegt noch die Aufgabe zugrunde, eine Anordnung zur Geräuschanpassung anzugeben, mit welcher ein vorhandenes Arbeitsgerät leicht nachgerüstet werden kann.

Diese Aufgabe wird durch eine Anordnung mit den Merkmalen des Anspruchs 17 gelöst.

Grundlage der Erfindung ist zunächst die Erkenntnis, dass es nicht die absolute Lautstärke ist, welche eine vorteilhafte akustische Rückmeldung bewirkt, sondern dass es vielmehr auf eine bestimmte Verteilung des Schallpegels innerhalb des hörbaren Frequenzspektrums ankommt. Die Erfindung basiert auch auf der Erkenntnis, dass das subjektive Empfinden von Kraft und Leistungsfähigkeit, aber auch die objektive Wahrnehmung von Laständerungen im Betrieb vorrangig durch die tieferen Frequenzen im Bereich unterhalb von 1 kHz bestimmt wird. Während Arbeitsgeräte mit Verbrennungsmotor in diesem tiefen Frequenzbereich signifikante Geräuschanteile entwickeln, sind solche Geräuschanteile des Betriebsgeräusches bei elektrisch betriebenen Arbeitsgeräten im unkorrigierten Zustand nach dem Stand der Technik sehr viel weniger ausgeprägt und fehlen deshalb dem Benutzer als akustische Rückmeldung.

Auf diesen Erkenntnissen aufbauend ist deshalb nach der Erfindung vorgesehen, dass im Betrieb mittels eines dazu ausgelegten Geräuschgenerators zusätzlich zum unkorrigierten Betriebsgeräusch ein Ergänzungsgeräusch erzeugt wird, welches sich mit dem Betriebsgeräusch zu einem Gesamtgeräusch mit einem Gesamtschalldruckpegel überlagert, und wobei der Hauptanteil des Ergänzungsgeräusches in einem Anpassungsfrequenzbereich unterhalb von 1 kHz liegt. Hierdurch werden vorrangig zwei Ergebnisse erzielt: Zum einen wird die subjektive und die objektive Wahrnehmung des resultierenden Gesamtgeräusches im Sinne einer akustischen Rückmeldung für den Benutzer deutlich verbessert. Das Vertrauen in die Leistungsfähigkeit des Gerätes steigt, und der tatsächliche Betriebszustand kann beispielsweise anhand von Drehzahlschwankungen besser wahrgenommen werden. Zum anderen führt die erfindungsgemäße Schwerpunktsetzung unterhalb von 1 kHz zu keiner erheblichen oder allenfalls geringfügigen Vergrößerung des bewerteten kumulierten Gesamtschalldruckpegels, so dass die vom menschlichen Gehör wahrgenommene Gesamtlautstärke im Wesentlichen unverändert bleibt. Die Vorzüge des elektrischen Antriebs insbesondere hinsichtlich der Akzeptanz in dichter besiedelten Gebieten bleiben erhalten. Dies gilt insbesondere für den bevorzugten Fall, dass das Ergänzungsgeräusch derart bemessen ist, dass der A-bewertete kumulierte Gesamtschalldruckpegel nicht mehr als 1,0 dB(A) und insbesondere nicht mehr als 0,5 dB(A) größer als der A-bewertete kumulierte Betriebsschalldruckpegel des unkorrigierten Betriebsgeräusches ist.

Das Ergänzungsgeräusch weist eine über sein Frequenzbereich verteilte Schallenergie auf. Als wesentliche Voraussetzung für das Erreichen der vorstehend beschriebenen Vorzüge wurde schon genannt, dass der Hauptanteil des Ergänzungsgeräusches in einem Anpassungsfrequenzbereich unterhalb von 1 kHz liegt. Hierfür werden vorteilhaft mindestens 70%, bevorzugt mindestens 80% und insbesondere mindestens 90% der Schallenergie des Ergänzungsgeräusches im Anpassungsfrequenzbereich erzeugt. Hierdurch wird sichergestellt, dass einerseits das Klangempfinden in gewünschter Weise korrigiert wird, während andererseits der das Lautstärkeempfinden kennzeichnende kumulierte Gesamtschalldruckpegel nicht oder nicht erheblich ansteigt.

In bevorzugter Weiterbildung der Erfindung wird die Drehzahl einer Antriebswelle insbesondere des Antriebsmotors als Grundfrequenz zur Festlegung des Ergänzungsgeräusches herangezogen, wobei das Ergänzungsgeräusch abhängig von der Grundfrequenz eingestellt wird. Änderungen in der Drehzahl führen damit auch zu Änderungen des Ergänzungsgeräusches in analoger Weise. Hierdurch kann die tatsächlich erreichte Drehzahl besser wahrgenommen werden. Insbesondere aber sind Drehzahlschwankungen deutlich besser akustisch zu erkennen, so dass der Benutzer ein besseres Gefühl dafür entwickelt, welche Last das Werkzeug beispielsweise in Form einer Sägekette beim Eingriff ins Holz erfährt. Der Benutzer kann damit leichter und mit besserer Feinfühligkeit den auszuübenden Druck auf das Sägeschwert oder im Falle einer Heckenschere den Vorschub durch das Geäst einstellen.

Die vorstehend beschriebenen Wirkungen sind besonders ausgeprägt in einer bevorzugten Ausführungsform, in welcher das Anpassungsfrequenzbereich des Ergänzungsgeräusches mindestens ein einzelnes Frequenzband und insbesondere mehrere Frequenzbänder umfasst, wobei das Frequenzband eine Bezugsfrequenz mit maximalem Schalldruckpegel beinhaltet, und wobei die Bezugsfrequenz abhängig von der durch den Antriebsmotor vorgegebenen Grundfrequenz eingestellt wird. Mit anderen Worten wird ein deutlich hörbares, möglichst schmales Frequenzband erzeugt, dessen Bezugsfrequenz mit der Drehzahl der Antriebswelle korrespondiert und sich mit ändernder Drehzahl ebenfalls ändert bzw. korrespondierend verschiebt. Hierdurch ist die akustische Wahrnehmung der aktuellen Drehzahl besonders deutlich.

In vorteilhafter Weiterbildung umfasst im stationären Betrieb des Arbeitsgerätes ein einzelnes Frequenzband des Ergänzungsgeräusches ein ganzzahliges Vielfaches der halben Grundfrequenz. Je nach Breite des Frequenzbandes kann es ausreichen, wenn das genannte ganzzahlige Vielfache irgendwo in diesem Frequenzband liegt. Bevorzugt ist jedoch die Bezugsfrequenz des Frequenzbandes ein ganzzahliges Vielfaches der halben Grundfrequenz. Bezugsfrequenz und ganzzahliges Vielfaches sind also deckungsgleich. Damit wird das Betriebsgeräusch innerhalb des Anpassungsfrequenzbereichs verstärkt wahrnehmbar, ohne in seinen charakteristischen Frequenzen verändert zu werden. Insgesamt entsteht ein satter, kräftiger Klang, der das Vertrauen in das Gerät stärkt, ohne dabei an Authentizität eingebüßt zu haben.

In einer bevorzugten Ausführung beinhaltet das Ergänzungsgeräusch im Anpassungsfrequenzbereich mehrere Frequenzbänder mit mindestens solchen Bezugsfrequenzen, deren ganzzahlige Vielfache der halben Grundfrequenz 1 und 2, bevorzugt 1 bis 3 und insbesondere 1 bis 5 betragen. Hierdurch wird erreicht, dass das entstehende Geräusch ausgewogen und ohne Überbetonung der unteren und/oder oberen Frequenzen klingt.

Das unkorrigierte Betriebsgeräusch weist einen über den Anpassungsfrequenzbereich verteilten Verlauf eines Betriebsschalldruckpegels auf. Vorteilhaft ist das Ergänzungsgeräusch derart an den Verlauf des Betriebsschalldruckpegels angepasst, dass bei der Bezugsfrequenz des mindestens einen Frequenzbandes ein korrespondierender Gesamtschalldruckpegel mindestens 3 dB höher ist als der korrespondierende Betriebsschalldruckpegel. Hierdurch wird der antriebsseitig generierte, akustisch als signifikant empfundene "Peak" im Frequenzgang des unkorrigierten Betriebsgeräusches ausreichend verstärkt und damit in seiner Wahrnehmung wie gewünscht hervorgehoben.

Das unkorrigierte Betriebsgeräusch weist einen frequenzabhängigen Verlauf des Betriebsschalldruckpegels mit einem Maximalwert auf. Das Ergänzungsgeräusch ist zweckmäßig derart an den Verlauf des Betriebsschalldruckpegels angepasst, dass bei der Bezugsfrequenz des mindestens einen Frequenzbandes ein korrespondierender Gesamtschalldruckpegel nicht mehr als 20 dB höher ist als der Maximalwert des Betriebsschalldruckpegels. Hierdurch wird sichergestellt, dass die akustische Korrektur nicht überbetont wird, und dass die Gesamtlautstärke nicht übermäßig ansteigt.

Im praktischen Betrieb ist nur selten ein stationärer Zustand erreichbar. Vielmehr ist das Arbeitsgeschehen im Regelfall sehr dynamisch mit schwankenden Drehzahlen. Zur besseren Wahrnehmung dieser Dynamik ist in einer bevorzugten Ausführungsform vorgesehen, dass im beschleunigenden oder verzögernden Betrieb des Arbeitsgerätes das Frequenzband im Vergleich zum stationären Betrieb in Richtung höherer bzw. niedriger Frequenzen verschoben wird.

Für die Erzeugung des Ergänzungsgeräusches kommen verschiedene Einrichtungen wie Piezoschallgeber oder die entsprechend angesteuerten Wicklungen des elektrischen Antriebsmotors in Betracht. Bevorzugt umfasst der Geräuschgenerator einen am Arbeitsgerät angebrachten Lautsprecher, welcher das Ergänzungsgeräusch für den Benutzer wahrnehmbar macht. Ein solcher mit Spule und Membran ausgestatteter Lautsprecher kann bei geringer Leistungsaufnahme innerhalb des Anpassungsfrequenzbereichs ein Ergänzungsgeräusch mit ausreichender Vielfalt, das heißt mit variierenden Frequenzen und mit der gewünschten Spektralverteilung in der geforderten Qualität bereitstellen.

Für die Positionierung und Ausrichtung des Lautsprechers kommen verschiedene Optionen in Betracht. Bevorzugt ist der Lautsprecher in gewöhnlicher Arbeitshaltung des Arbeitsgerätes auf den Kopf des Benutzers gerichtet und zweckmäßig auf der Oberseite des Arbeitsgerätes angeordnet, wodurch das erzeugte Ergänzungsgeräusch deutlich und ohne größere Dämpfungen für den Benutzer hörbar ist. Er kann als separates Bauteil in einem separaten Gehäuse untergebracht sein, ist jedoch vorteilhaft in ein Bauteil des Arbeitsgerätes und insbesondere in einen Handschutz des Arbeitsgerätes integriert. Damit ist der Lautsprecher ohne Beeinträchtigung seiner Wirkung gut gegen äußere Einflüsse geschützt, ohne das Bauvolumen des Arbeitsgerätes nachteilig zu vergrößern.

Es können nahezu beliebige elektrische Arbeitsgeräte gemäß der Erfindung modifiziert werden. Bevorzugt handelt es sich bei dem zugrunde liegenden Arbeitsgerät um eine Kettensäge oder eine Heckenschere. Es hat sich gezeigt, dass hier der Mangel an akustischer Rückmeldung ohne Korrektur und das Verbesserungspotential infolge der erfindungsgemäßen Geräuschanpassung besonders ausgeprägt ist.

Die Erfindung eignet sich auch dafür, vorhandene Arbeitsgeräte nachzurüsten. Hierzu ist eine Anordnung zur Geräuschanpassung eines durch einen elektrischen Antriebsmotor angetriebenen handgeführten Arbeitsgerätes vorgesehen, welche einen Handschutz für das Arbeitsgerät sowie einen Geräuschgenerator mit einem Lautsprecher umfasst. Der Geräuschgenerator ist bevorzugt dazu ausgelegt, das vorstehend zusammengefasste und nachfolgend noch näher beschriebene, erfindungsgemäße Verfahren auszuführen. In einfacher und kostensparender Weise kann ein alter Handschutz entfernt und gegen die erfindungsgemäße Anordnung ersetzt werden. Hierdurch können die oben beschriebenen erfindungsgemäßen Vorteile in einfacher Weise auch bei einem bereits vorhandenen Arbeitsgerät zugänglich gemacht werden.

In einer bevorzugten Ausführungsform ist der Lautsprecher in den Handschutz integriert. Lautsprecher und Handschutz bilden dadurch eine leicht austauschbare Baueinheit. Der Geräuschgenerator weist eine Generator- und Verstärkereinheit zur Ansteuerung des Lautsprechers auf, mit welcher zunächst der Frequenzgang des Ergänzungsgeräusches erzeugt und dann als verstärktes Ausgangssignal an den Lautsprecher ausgegeben wird. Diese Generator- und Verstärkereinheit als Teil der erfindungsgemäßen Anordnung zur Geräuschanpassung kann als separate Einheit unabhängig vom Handschutz in einen geeigneten Bereich des Arbeitsgerätes eingebaut bzw. nachgerüstet werden. Bevorzugt ist jedoch auch die Generator- und Verstärkereinheit in den Handschutz integriert. Der Umrüstungsaufwand beschränkt sich damit auf ein Minimum. Nach Austausch des Handschutzes muss lediglich eine Signalverbindung zur Drehzahl der Antriebswelle bzw. des Antriebsmotors und ggf. auch eine Stromversorgung herbeigeführt werden.

In einem weiteren Aspekt der Erfindung ist der Geräuschgenerator nicht notwendigerweise, sondern nur optional dazu ausgelegt, das vorstehende erfindungsgemäße Verfahren auszuführen. Es kann also auch auf die beschriebene Geräuschanpassung verzichtet werden. Jedenfalls besteht eine erfindungsgemäße Möglichkeit darin, mit oder ohne Geräuschanpassung auch andere Geräusche auszugeben. So kann beispielsweise ein Radioempfänger, und Musikplayer (MP3-Player) oder dergleichen integriert sein, wobei dann die erfindungsgemäße Anordnung dazu genutzt wird, beispielsweise in Arbeitspausen ein Radioprogramm oder eine Musikdatei abzuspielen.

Ein Ausführungsbeispiel der Erfindung ist nachfolgend anhand der Zeichnung näher beschrieben. Es zeigen:
- Fig. 1: in einer perspektivischen Ansicht ein erfindungsgemäß ausgeführtes elektrisches Arbeitsgerät am Beispiel einer Kettensäge mit im Handschutz integriertem Lautsprecher zur Erzeugung des erfindungsgemäßen Ergänzungsgeräusches, und
- Fig. 2: in einer Diagrammdarstellung die Frequenzspektren des unkorrigierten Betriebsgeräusches, des Ergänzungsgeräusches und des damit erzielten Gesamtgeräusches.

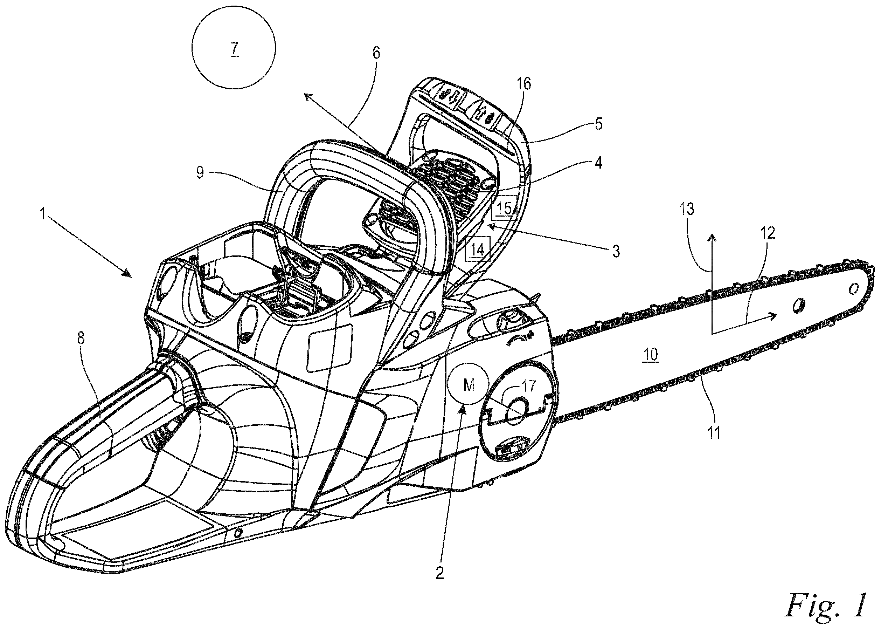

Fig. 1 zeigt in einer perspektivischen Ansicht ein erfindungsgemäß modifiziertes handgeführtes Arbeitsgerät mit einem nur schematisch angedeuteten elektrischen Antriebsmotor 2. Als bevorzugtes Beispiel für ein solches Arbeitsgerät ist hier eine Kettensäge 1 mit einer Führungsschiene 10 und mit einer um die Führungsschiene 10 umlaufenden, vom Antriebsmotor 2 angetriebenen Sägekette 11 gewählt. Es kann aber auch eine elektrische Heckenschere oder dergleichen vorgesehen sein, wofür dann die nachstehende Beschreibung in analoger Weise gilt.

Der Antriebsmotor 2 weist eine schematisch angedeutete Antriebswelle 17 auf, mittels derer er über ein nicht dargestelltes Kettenrad die Sägekette 11 antreibt. Vorliegend handelt es sich dabei um einen Direktantrieb, bei dem die Antriebswelle 17 gleichzeitig auch die Motorwelle des Antriebsmotors 2 ist. Es kann aber auch zweckmäßig sein, die Antriebswelle 17 getrennt von der Motorwelle auszuführen und diese beispielsweise in Verbindung mit einem schnell laufenden Antriebsmotor 2 über ein zwischengeschaltetes Untersetzungsgetriebe mit verringerter Drehzahl und erhöhtem Drehmoment in Drehung zu versetzen.

Die Führungsschiene 10 erstreckt sich entlang einer Längsachse, welche eine Längsrichtung 12 der Kettensäge 1 vorgibt. In der Ebene der Führungsschiene 10 und etwa senkrecht zur Längsrichtung 12 liegt eine Hochrichtung 13. Die Kettensäge 1 ist hier in gewöhnlicher Arbeitshaltung gezeigt, in welcher bezogen auf die Gewichtskraftrichtung die Längsrichtung 12 etwa horizontal und die Hochrichtung 13 etwa vertikal ausgerichtet sind. In dieser gewöhnlichen Arbeitshaltung wird die Kettensäge 1 seitens des Benutzers von oben gegriffen und mit je einer Hand an einem hinteren Handgriff 8 und an einem vorderen Griffrohr 9 gehalten. Hierdurch befindet sich in der gewöhnlichen Arbeitshaltung der nur schematisch angedeutete Kopf 7 des Benutzers oberhalb des hinteren Bereichs der Kettensäge 1.

Die vordere Hand am Griffrohr 9 wird durch einen Handschutz 5 gegen die vom elektrischen Antriebsmotor 2 angetriebene und um eine Führungsschiene 10 umlaufende Sägekette 11 geschützt. Bei Kickback oder anderen unvorhergesehenen Bewegungen der Kettensäge 1 in einer Schwenkbewegung nach oben/hinten wird der Handschutz 5 gegen die vordere Hand des Benutzers gedrückt. Hierdurch und/oder durch die Massenträgheit des Handschutzes schwenkt dieser relativ zur Kettensäge nach vorne und löst unmittelbar eine nicht dargestellte Kettenbremse aus.

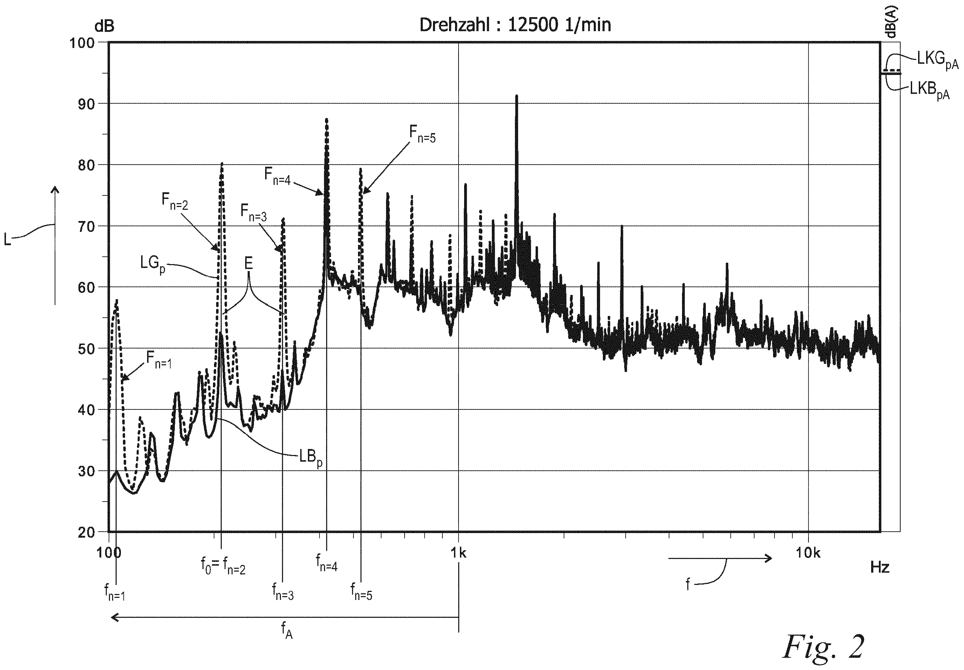

Im Betrieb erzeugt die Kettensäge 1 mittels des elektrischen Antriebsmotors 2 und der davon angetriebenen Sägekette 11 ein Geräusch, welches in nachfolgend näher beschriebener Weise einer Geräuschanpassung unterzogen wird. Ohne diese Geräuschanpassung wird das Geräusch nachfolgend im Zusammenhang mit Fig. 2 als unkorrigiertes Betriebsgeräusch bezeichnet. Für die Geräuschanpassung und/oder andere, weiter unten noch beschriebene Zwecke verfügt die Kettensäge 1 über einen Geräuschgenerator 3.

Teil des Geräuschgenerators 3 ist ein Lautsprecher 4 sowie eine nur schematisch als Block angedeutete Generator- und Verstärkereinheit 14. Die Generator- und Verstärkereinheit 14 generiert den Frequenzgang eines Geräusches und verstärkt diesen als Ausgangssignal auf ein geeignetes Leistungsniveau derart, dass der Lautsprecher 4 das genannte Ausgangssignal als Geräusch in gewünschter Lautstärke bzw. mit gewünschtem Schalldruckpegel L_{P} (Fig. 2) ausgibt.

In einem Aspekt der Erfindung wird mit dem Geräuschgenerator 3 ein nachfolgend im Zusammenhang mit Fig. 2 beschriebenes Ergänzungsgeräusch erzeugt und für den Benutzer der Kettensäge 1 wahrnehmbar gemacht. Alternativ oder zusätzlich kann der Geräuschgenerator 3 mit einem schematisch als Block angedeuteten Radioempfänger 15 oder mit einer anderen Einheit zum Abspielen von Musik wie beispielsweise einem MP3-Player verbunden sein. In diesem Fall kann der Geräuschgenerator 3 ein Radioprogramm, Musik und/oder dergleichen ausgeben und beispielsweise in Arbeitspausen zur Unterhaltung eingesetzt werden.

Der Lautsprecher 4 kann beispielsweise in einen Gehörschutz integriert sein, welcher vom Benutzer auf dessen Ohren getragen wird. Für eine gute Wahrnehmbarkeit des erzeugten Geräusches, insbesondere des Ergänzungsgeräusches (Fig. 2) auch ohne einen solchermaßen angepassten Gehörschutz ist der Lautsprecher 4 im gezeigten Ausführungsbeispiel auf der Oberseite der Kettensäge 1 angeordnet. Außerdem ist er in ein Bauteil der Kettensäge 1 integriert, wozu ein Gehäuseteil oder dergleichen zweckmäßig sein kann. Im gezeigten Ausführungsbeispiel ist der Lautsprecher 4 in den Handschutz 5 integriert. Dies bedeutet, dass ein Teil des Handschutzes 5, hier ein Kunststoffspritzgussteil den Lautsprecher 4 aufnimmt und damit als Gehäuse für diesen dient. Der entsprechende Abschnitt des Handschutzes 5 ist für diesen Zweck als Schutzgitter ausgestaltet, welches schalldurchlässig ist, ansonsten aber den Lautsprecher 4 gegen äußere Einflüsse schützt.

Es kann zweckmäßig sein, die Generator- und Verstärkereinheit 14 und/oder den Radioempfänger 15 im Gehäuse des Arbeitsgerätes oder an anderer geeigneter Stelle zu positionieren. Im gezeigten bevorzugten Ausführungsbeispiel sind zusätzlich zum Lautsprecher 4 auch die Generator- und Verstärkereinheit 14 und der Radioempfänger 15 im Handschutz 5 integriert. Für die Versorgung des Radioempfängers 15 mit einem Empfangssignal ist außerdem eine schematisch angedeutete Antenne 16 in den Handschutz 5 integriert. Damit ist eine eigenständige Funktionseinheit gebildet, die als Austauscheinheit gegen einen herkömmlichen Handschutz 5 ausgetauscht werden kann, und wodurch ein herkömmliches Arbeitsgerät mit der hier beschriebenen Geräuschfunktion nachgerüstet werden kann. Je nach Ausgestaltung handelt es sich also um eine Anordnung zum Abspielen von Radio- oder Musikprogramm und/oder, entsprechend dem hier gezeigten Ausführungsbeispiel, um eine Anordnung zur Geräuschanpassung des Arbeitsgerätes in weiter unten näher beschriebener Weise.

Der Lautsprecher 4 kann verschiedene geeignete Bauformen haben und ist hier in üblicher Bauweise mit Membran, Permanentmagnet und elektrischer Spule aufgebaut. Der Lautsprecher hat eine zentrische Abstrahlrichtung 6, die vorliegend in Normalrichtung zur Membranebene weist. Der Lautsprecher 4 ist derart an der Kettensäge 1 befestigt, dass er in der gezeigten gewöhnlichen Arbeitshaltung mit seiner Abstrahlrichtung 6 auf den Kopf 7 des Benutzers gerichtet ist. Hierzu ist die Abstrahlrichtung 6 zumindest in der Hochrichtung 13 nach oben, hier auch ergänzend in der Längsrichtung 12 nach hinten gerichtet. Eine seitliche Neigung fehlt, oder ist zumindest kleiner ausgeprägt als die Neigung nach hinten, so dass die Abstrahlrichtung 6 zumindest vorrangig in der durch die Längsrichtung 12 und die Hochrichtung 13 aufgespannten Ebene liegt.

Fig. 2 zeigt in einer Diagrammdarstellung die spektralen Verteilungen, also die Frequenzgänge der von der Kettensäge 1 nach Fig. 1 im Betrieb erzeugten Geräusche. Dabei ist auf der horizontalen Abszisse die Frequenz f der Geräusche in Hz und auf der vertikalen Ordinate der Schalldruckpegel L_{P} der jeweiligen Geräusche in dB aufgetragen. Dabei handelt es sich um nach ISO 22868 ermittelte Schalldruckpegel Lp, welche mit einem Messmikrofon an simulierter Stelle des Ohres vom Benutzer, nämlich in der Hochrichtung 13 etwa 700 mm oberhalb des Griffrohres 9, und in der Längsrichtung 12 etwa mittig des Gerätekörpers, welcher sich rückwärtig hinter der Führungsschiene 10 befindet, gemessen wurden. Ohne jetzt schon ins Detail zu gehen, kann man auf den ersten Blick erkennen, dass die spektrale Verteilung des Schalldruckpegels L_{P} des hier zugrundeliegenden elektrisch angetriebenen Arbeitsgerätes in zwei Bereiche aufgeteilt werden kann. Oberhalb einer Frequenz f von etwa 1 kHz weist der Pegelverlauf zwar verschiedene Peaks und Ripple auf, verläuft aber abgesehen davon im Mittel innerhalb eines vergleichsweise schmalen Bandes von Pegelwerten. Unterhalb dieser Frequenz f von etwa 1 kHz fällt jedoch der Schalldruckpegel L_{P} im Trend, also abgesehen von einigen Peaks, zu tieferen Frequenzen hin deutlich ab.

Zunächst sei auf die spektrale Verteilung, also auf den Frequenzgang des unkorrigierten Betriebsgeräusches eingegangen. Dies ist das vom Arbeitsgerät erzeugte Betriebsgeräusch, ohne dass dabei der Geräuschgenerator 3 (Fig. 1) aktiv ist. Der Betriebsschalldruckpegel LB_{P} des Betriebsgeräusches ist in seinem Verlauf mit durchgezogener Linie dargestellt. Für die hier zugrunde liegende Beispielmessung arbeitet der elektrische Antriebsmotor 2 bzw. die Antriebswelle 17 mit einer Drehzahl von 12.500 Upm bzw. 12.500 1/min, was einer Grundfrequenz f₀ von 208 Hz entspricht. Bei der Grundfrequenz f₀ weist das Frequenzspektrum des Betriebsgeräusches, also der Verlauf des Betriebsschallpegels LB_{P} über der Frequenz f naturgemäß eine Spitze bzw. einen Peak auf. Weitere Spitzen bzw. Peaks finden sich bei ganzzahligen Vielfachen n der halben Grundfrequenz f₀, also bei fₙ₌₁, f₀ = fₙ₌₂, fₙ₌₃ und so fort, was durch entsprechende Oberschwingungen des Antriebsmotors 2 und des Werkzeuges, also hier der Sägekette 11 erzeugt wird. Diese werden im Rahmen der Erfindung als charakteristisch für die akustische Rückmeldung der Kettensäge 1 an den Benutzer angesehen.

Die Kettensäge 1 und ihr Geräuschgenerator 3 sind zur Ausführung des erfindungsgemäßen Verfahrens ausgelegt, wonach zusätzlich zum unkorrigierten Betriebsgeräusch ein Ergänzungsgeräusch mittels des Geräuschgenerators 3 erzeugt und über den Lautsprecher 4 für den Benutzer wahrnehmbar gemacht wird. Das Ergänzungsgeräusch addiert sich mit dem unkorrigierten Betriebsgeräusch zu einem Gesamtgeräusch mit einem Gesamtdruckschallpegel LG_{P}, dessen Frequenzgang, also Pegelverlauf über der Frequenz f in Fig. 2 mit gestrichelter Linie dargestellt ist.

Zunächst ist in Fig. 2 erkennbar, dass der Hauptanteil des Ergänzungsgeräusches in einem Anpassungsfrequenzbereich f_{A} unterhalb von 1 kHz liegt. Das Ergänzungsgeräusch weist eine über seinen Frequenzbereich verteilte Schallenergie E auf, die hier als Fläche zwischen der durchgezogenen Linie vom Betriebsschalldruckpegel LB_{P} des Betriebsgeräusches und der gestrichelten Linie vom Gesamtdruckschallpegel LG_{P} des Gesamtschalldruckpegels verstanden werden kann. Es ist augenfällig, das oberhalb des Anpassungsfrequenzbereichs f_{A}, also oberhalb von etwa 1 kHz das Ergänzungsgeräusch keine oder nur noch eine geringe Rolle spielt. Konkret bedeutet dies, dass mindestens 70%, bevorzugt mindestens 80% und im gezeigten bevorzugten Ausführungsbeispiel mindestens 90% der Schallenergie E des Ergänzungsgeräusches im Anpassungsfrequenzbereich f_{A} erzeugt werden. Der oben schon erwähnte absinkende Bereich des unkorrigierten Betriebsgeräusches wird also quasi akustisch zumindest teilweise aufgefüllt, während der höhere Frequenzbereich oberhalb von 1 kHz im Wesentlichen unverändert bleibt.

Da die erfindungsgemäße Geräuschkorrektur vorrangig im Anpassungsfrequenzbereich f_{A}, also unterhalb von 1 kHz erfolgt, hat dies eine erste wichtige Konsequenz: Da bei diesen tiefen Frequenzen der unkorrigierte Betriebsschalldruckpegel LB_{P} vergleichsweise gering ist, erhöht sich durch das Aufspielen des Ergänzungsgeräusches die empfundene Gesamtlautstärke praktisch nicht. Im konkret gezeigten Beispiel weist das unkorrigierte Betriebsgeräusch einen über den hörbaren Frequenzbereich bestimmten, A-bewerteten kumulierten Betriebsschalldruckpegel LkB_{pA} von 94,9 dB(A) auf, während ein korrespondierender A-bewerteter kumulierter Gesamtschalldruckpegel LkG_{pA} des aus dem unkorrigierten Betriebsgeräusch und dem Ergänzungsgeräusch E resultierenden Gesamtgeräusches kaum mehr, nämlich nur 95,4 dB(A) beträgt. Insgesamt ist das Ergänzungsgeräusch derart bemessen, dass der A-bewertete kumulierte Gesamtschalldruckpegel LkG_{pA} nicht mehr als 1,0 dB(A) und vorliegend nicht mehr als 0,5 dB(A) größer als der A-bewertete kumulierten Betriebsschalldruckpegel LkB_{pA} ist.

Der in seinem Pegel zu tieferen Frequenzen hin absinkende Bereich des unkorrigierten Betriebsgeräusches B wird innerhalb des Anpassungsfrequenzbereichs f_{A} nicht einfach nur gleichmäßig "aufgefüllt". Vielmehr wird die Drehzahl der Antriebswelle 17 für das Werkzeug, hier also für die Sägekette 11 als Grundfrequenz f₀ zur Festlegung des Ergänzungsgeräusches E herangezogen, wobei dann das Ergänzungsgeräusch E abhängig von der Grundfrequenz f₀ wie folgt eingestellt wird:
Das Ergänzungsgeräusch wird derart erzeugt, dass es im Anpassungsfrequenzbereich f_{A} mindestens ein einzelnes Frequenzband Fₙ umfasst, wobei ein solches Frequenzband Fₙ jeweils eine Bezugsfrequenz fₙ aufweist. Mit dem Begriff Bezugsfrequenz fₙ ist hier diejenige Frequenz f gemeint, bei der der Schalldruckpegel innerhalb dieses Frequenzbandes Fₙ maximal ist. Gemäß der Darstellung nach Fig. 2 weist das Ergänzungsgeräusch innerhalb des Anpassungsfrequenzbereichs f_{A} mehrerer solcher Frequenzbänder Fₙ₌₁, Fₙ₋₂, Fₙ₋₃, Fₙ₌₄, Fₙ₌₅ mit zugehörigen Bezugsfrequenzen fₙ₌₁, fₙ₌₂, fₙ₌₃, fₙ₌₄, fₙ₌₅ auf, welche als Peaks mit limitierter Bandbreite erkennbar sind. Anstelle einer Ausgestaltung mit bestimmter Bandbreite können auch Frequenzbänder Fₙ in Form von angenäherten Spikes ohne relevante Bandbreite zweckmäßig sein. Jedenfalls werden die Bezugsfrequenzen fₙ abhängig von der durch den Antriebsmotor 2 bzw. von der durch die Drehzahl der Antriebswelle 17 vorgegebenen Grundfrequenz f₀ eingestellt. Dies bedeutet zunächst, dass bei sich verändernder Drehzahl bzw. Grundfrequenz f₀ auch die Bezugsfrequenzen fₙ entsprechend verschoben werden. Eine höhere Drehzahl bzw. Grundfrequenz f₀ führt zu höheren Bezugsfrequenzen fₙ und eine niedrigere Drehzahl bzw. Grundfrequenz f₀ zu entsprechend niedrigeren Bezugsfrequenzen fₙ.

Für den in Fig. 2 dargestellten stationären Fall einer konstanten Drehzahl bzw. Grundfrequenz f₀ ist im gezeigten bevorzugten Ausführungsbeispiel vorgesehen, dass zumindest eines der Frequenzbänder Fₙ des Ergänzungsgeräusches ein ganzzahliges Vielfaches n der halben Grundfrequenz f₀ umfasst. Vorliegend gilt dies für mehrere Frequenzbänder Fₙ des Ergänzungsgeräusches, und insbesondere für die ersten fünf Frequenzbänder Fₙ₌₁, Fₙ₌₂, Fₙ₌₃, Fₙ₌₄, Fₙ₌₅, bei denen also die ganzzahligen Vielfachen n der halben Grundfrequenz f₀ vorliegend 1 bis 5 betragen. Natürlich können noch weitere Frequenzbänder mit zusätzlichen ganzzahligen Vielfachen n vorgesehen sein. Ebenso kann es im Rahmen der Erfindung zweckmäßig sein, einzelne Frequenzbänder auszulassen. Jedenfalls sollten bevorzugt solche Frequenzbänder des Ergänzungsgeräuschs mit ganzzahligen Vielfachen von n gleich 1 und 2 und insbesondere von n gleich 1 bis 3 vorhanden sein.

Die zugehörige Bezugsfrequenzen fₙ, hier fₙ₌₁, fₙ₌₂, fₙ₌₃, fₙ₌₄, fₙ₌₅ müssen nicht exakt mit den ganzzahligen Vielfachen n der halben Grundfrequenz f₀ übereinstimmen, wobei aber die ganzzahligen Vielfachen n der halben Grundfrequenz f₀ im stationären Betrieb zumindest innerhalb der Frequenzbänder Fₙ, hier Fₙ₌₁, Fₙ₌₂, Fₙ₌₃, Fₙ₌₄, Fₙ₌₅ liegen sollten. Vorliegend herrscht aber die erwähnte Übereinstimmung, wonach die Bezugsfrequenzen fₙ₌₁, fₙ₌₂, fₙ₌₃, fₙ₌₄, fₙ₌₅ der Frequenzbänder Fₙ₌₁, Fₙ₌₂, Fₙ₌₃, Fₙ₌₄, Fₙ₌₅ auf die zugeordneten ganzzahligen Vielfachen n der halben Grundfrequenz f₀ eingestellt sind. Jedenfalls wird erreicht, dass die als charakteristisch für den Betriebszustand empfundenen und für eine akustische Rückmeldung wichtigen Peaks bei den ganzzahligen Vielfachen n der halben Grundfrequenz f₀, also bei fₙ₌₁, f₀ = fₙ₌₂, fₙ₌₃ und so fort im Verlauf des Betriebsschallpegels L_{B} verstärkt und in Form des Gesamtgeräusches G mit einem entsprechenden Verlauf des Gesamtschallpegels L_{G} besser wahrnehmbar gemacht werden.

Des Weiteren ist noch erkennbar, dass bestimmte Unter- und Obergrenzen für die Stärke des Ergänzungsgeräusches eingehalten sind. Zum einen ist das Ergänzungsgeräusch derart an den Verlauf des Betriebsschalldruckpegels LBₚ angepasst, dass bei den ausgewählten Bezugsfrequenzen fₙ der Frequenzbänder Fₙ der entstehende korrespondierende Gesamtschalldruckpegel LGₚ mindestens 3 dB höher ist als der korrespondierende Betriebsschalldruckpegel LBₚ. Beispielhaft sei hier auf die Bezugsfrequenz f₀ = fₙ₌₂ verwiesen, wo der Gesamtschalldruckpegel LGₚ etwa 80 dB beträgt und damit 28 dB, also mindestens 3 dB höher ist als der korrespondierende Betriebsschalldruckpegel LBₚ in Höhe von 52 dB. Zum anderen wird auch eine bestimmte Obergrenze nicht überschritten: Bei den ausgewählten Bezugsfrequenzen fₙ der Frequenzbänder Fₙ ist der entstehende korrespondierende Gesamtschalldruckpegel LGₚ nicht mehr als 40 dB und insbesondere nicht mehr als 30 dB höher als der korrespondierende Betriebsschalldruckpegel LBₚ. Erneut sei hier beispielhaft auf die Bezugsfrequenz f₀ = fₙ₌₂ verwiesen, wo der Gesamtschalldruckpegel LGₚ etwa 80 dB beträgt und damit 28 dB, also nicht mehr als 30 dB höher ist als der korrespondierende Betriebsschalldruckpegel LBₚ in Höhe von 52 dB.

Der vorstehend beschriebene Zustand kann auch im nichtstationären Betrieb, als beim Beschleunigen und/oder Verzögern beibehalten werden. Bevorzugt werden hierbei jedoch das Frequenzband Fₙ bzw. die Frequenzbänder Fₙ₌₁, Fₙ₌₂, Fₙ₌₃, Fₙ₌₄, Fₙ₌₅ im Vergleich zum stationären Betrieb in Richtung höherer bzw. niedriger Frequenzen verschoben. Hierdurch wird die Dynamik des Arbeitsbetriebes akustisch deutlicher hervorgehoben.

## Patentansprüche

1. Verfahren zur Geräuschanpassung eines durch einen elektrischen Antriebsmotor (2) angetriebenen handgeführten Arbeitsgerätes mittels eines Geräuschgenerators (3), wobei das Arbeitsgerät im Betrieb ein unkorrigiertes Betriebsgeräusch mit einem Betriebsschalldruckpegel (LBₚ) erzeugt, wobei im Betrieb mittels des Geräuschgenerators (3) zusätzlich zum unkorrigierten Betriebsgeräusch ein Ergänzungsgeräusch erzeugt wird, welches sich mit dem Betriebsgeräusch zu einem Gesamtgeräusch mit einem Gesamtschalldruckpegel (LGₚ) überlagert, und wobei der Hauptanteil des Ergänzungsgeräusches in einem Anpassungsfrequenzbereich (f_{A}) unterhalb von 1 kHz liegt.

2. Verfahren nach Anspruch 1,
**dadurch gekennzeichnet, dass** das unkorrigierte Betriebsgeräusch einen A-bewerteten kumulierten Betriebsschalldruckpegel (LkB_{pA}) aufweist, das ein aus dem unkorrigierten Betriebsgeräusch und dem Ergänzungsgeräusch resultierendes Gesamtgeräusch einen A-bewerteten kumulierten Gesamtschalldruckpegel (LkG_{pA}) aufweist, und dass das Ergänzungsgeräusch derart bemessen ist, dass der A-bewertete kumulierte Gesamtschalldruckpegel (LkG_{pA}) nicht mehr als 1,0 dB(A) und insbesondere nicht mehr als 0,5 dB(A) größer als der A-bewertete kumulierte Betriebsschalldruckpegel (LkB_{pA}) ist.

3. Verfahren nach Anspruch 1 oder 2,
**dadurch gekennzeichnet, dass** das Ergänzungsgeräusch eine über sein Frequenzbereich verteilte Schallenergie (E) aufweist, wobei mindestens 70%, bevorzugt mindestens 80% und insbesondere mindestens 90% der Schallenergie (E) des Ergänzungsgeräusches im Anpassungsfrequenzbereich (f_{A}) erzeugt werden.

4. Verfahren nach einem der Ansprüche 1 bis 3,
**dadurch gekennzeichnet, dass** die Drehzahl einer Antriebswelle (17) insbesondere des Antriebsmotors (2) als Grundfrequenz (f₀) zur Festlegung des Ergänzungsgeräusches herangezogen wird, und dass das Ergänzungsgeräusch abhängig von der Grundfrequenz (f₀) eingestellt wird.

5. Verfahren nach Anspruch 4,
**dadurch gekennzeichnet, dass** das Ergänzungsgeräusch im Anpassungsfrequenzbereich (f_{A}) mindestens ein einzelnes Frequenzband (Fₙ) und insbesondere mehrere Frequenzbänder (Fₙ) umfasst, wobei das Frequenzband (Fₙ) eine Bezugsfrequenz (fₙ) mit maximalem Schalldruckpegel beinhaltet, und wobei die Bezugsfrequenz (fₙ) abhängig von der durch den Antriebsmotor vorgegebenen Grundfrequenz (f₀) eingestellt wird.

6. Verfahren nach Anspruch 5,
**dadurch gekennzeichnet, dass** im stationären Betrieb des Arbeitsgerätes ein einzelnes Frequenzband (Fₙ) des Ergänzungsgeräusches ein ganzzahliges Vielfaches (n) der halben Grundfrequenz (f₀) umfasst, und dass insbesondere die Bezugsfrequenz (fₙ) des Frequenzbandes (Fₙ) ein ganzzahliges Vielfaches (n) der halben Grundfrequenz (f₀) ist.

7. Verfahren nach Anspruch 6,
**dadurch gekennzeichnet, dass** das Ergänzungsgeräusch im Anpassungsfrequenzbereich (f_{A}) mehrere Frequenzbänder (Fₙ) mit mindestens solchen Bezugsfrequenzen (fₙ) beinhaltet, deren ganzzahlige Vielfache (n) 1 und 2, bevorzugt 1 bis 3 und insbesondere 1 bis 5 betragen.

8. Verfahren nach einem der Ansprüche 5 bis 7,
**dadurch gekennzeichnet, dass** das unkorrigierte Betriebsgeräusch einen über den Anpassungsfrequenzbereich (f_{A}) verteilten Verlauf eines Betriebsschalldruckpegels (LBₚ) aufweist, und dass das Ergänzungsgeräusch derart an den Verlauf des Betriebsschalldruckpegels (LBₚ) angepasst ist, dass bei der Bezugsfrequenz (fₙ) des mindestens einen Frequenzbandes (Fₙ) ein entstehender korrespondierender Gesamtschalldruckpegel (LGₚ) mindestens 3 dB höher ist als der korrespondierende Betriebsschalldruckpegel (LBₚ).

9. Verfahren nach einem der Ansprüche 5 bis 8,
**dadurch gekennzeichnet, dass** das unkorrigierte Betriebsgeräusch einen über den Anpassungsfrequenzbereich (f_{A}) verteilten Verlauf eines Betriebsschalldruckpegels (LBₚ) aufweist, und dass das Ergänzungsgeräusch derart an den Verlauf des Betriebsschalldruckpegels (LBₚ) angepasst ist, dass bei der Bezugsfrequenz (fₙ) des mindestens einen Frequenzbandes (Fₙ) ein entstehender korrespondierender Gesamtschalldruckpegel (LGₚ) nicht mehr als 40 dB und insbesondere nicht mehr als 30 dB höher ist als der korrespondierende Betriebsschalldruckpegel (LBₚ).

10. Verfahren nach einem der Ansprüche 5 bis 9,
**dadurch gekennzeichnet, dass** im beschleunigenden oder verzögernden Betrieb des Arbeitsgerätes das Frequenzband (Fₙ) im Vergleich zum stationären Betrieb in Richtung höherer bzw. niedriger Frequenzen verschoben wird.

11. Handgeführtes Arbeitsgerät mit einem elektrischen Antriebsmotor (2) und mit einem Geräuschgenerator (3), wobei der Geräuschgenerator (3) dazu ausgelegt ist, das Verfahren nach einem der Ansprüche 1 bis 10 auszuführen.

12. Arbeitsgerät nach Anspruch 11,
**dadurch gekennzeichnet, dass** der Geräuschgenerator (3) einen am Arbeitsgerät angebrachten Lautsprecher (4) umfasst, welcher das Ergänzungsgeräusch für den Benutzer wahrnehmbar macht.

13. Arbeitsgerät nach Anspruch 12,
**dadurch gekennzeichnet, dass** der Lautsprecher (4) in gewöhnlicher Arbeitshaltung des Arbeitsgerätes auf den Kopf des Benutzers gerichtet ist.

14. Arbeitsgerät nach Anspruch 12 oder 13,
**dadurch gekennzeichnet, dass** der Lautsprecher (4) auf der Oberseite des Arbeitsgerätes angeordnet ist.

15. Arbeitsgerät nach einem der Ansprüche 12 bis 14,
**dadurch gekennzeichnet, dass** der Lautsprecher (4) in ein Bauteil des Arbeitsgerätes und insbesondere in einen Handschutz (5) des Arbeitsgerätes integriert ist.

16. Arbeitsgerät nach einem der Ansprüche 11 bis 15,
**dadurch gekennzeichnet, dass** das Arbeitsgerät eine Kettensäge (1) oder eine Heckenschere ist.

17. Anordnung zur Geräuschanpassung eines durch einen elektrischen Antriebsmotor (2) angetriebenen handgeführten Arbeitsgerätes, umfassend einen Handschutz (5) des Arbeitsgerätes sowie einen Geräuschgenerator (3) mit einem Lautsprecher (4), wobei der Geräuschgenerator (3) dazu ausgelegt ist, das Verfahren nach einem der Ansprüche 1 bis 10 auszuführen.

18. Anordnung nach Anspruch 17,
**dadurch gekennzeichnet, dass** der Lautsprecher (4) in den Handschutz (5) integriert ist.

19. Anordnung nach Anspruch 17 oder 18,
**dadurch gekennzeichnet, dass** der Geräuschgenerator (3) eine Generator- und Verstärkereinheit (14) zur Ansteuerung des Lautsprechers (4) aufweist, und dass die Generator- und Verstärkereinheit (14) in den Handschutz (5) integriert ist.
